(19) Europäisches Patentamt / European Patent Office / Office européen des brevets

(11) **EP 4 220 674 B1**

(12) **FASCICULE DE BREVET EUROPEEN**

(45) Date de publication et mention
de la délivrance du brevet:
**01.04.2026 Bulletin 2026/14**

(21) Numéro de dépôt: **23167146.2**

(22) Date de dépôt: **18.09.2019**

(51) Classification Internationale des Brevets (IPC):
*H01G 4/33* (2006.01)     *H01L 21/00* (2006.01)
*H01G 4/012* (2006.01)     *H10D 1/60* (2025.01)
*H10D 1/68* (2025.01)     *H01G 4/005* (2006.01)
*H10N 97/00* (2023.01)     *H01G 4/224* (2006.01)

(52) Classification Coopérative des Brevets (CPC):
**H01G 4/33; H01G 4/012; H10D 1/042; H10D 1/716;**
H01G 4/005; H01G 4/224; H10D 1/714

(54) **CONDENSATEUR VERTICAL**

**VERTIKALER KONDENSATOR**

**VERTICAL CAPACITOR**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.09.2018 FR 1858585**

(43) Date de publication de la demande:
**02.08.2023 Bulletin 2023/31**

(62) Numéro(s) de document de la (des) demande(s)
initiale(s) en application de l'article 76 CBE:
**19197934.3 / 3 627 526**

(73) Titulaire: **STMicroelectronics (Tours) SAS
37100 Tours (FR)**

(72) Inventeur: **BOUFNICHEL, Mohamed
37380 MONNAIE (FR)**

(74) Mandataire: **Cabinet Beaumont
4, Place Robert Schuman
B.P. 1529
38025 Grenoble Cedex 1 (FR)**

(56) Documents cités:
**EP-A2- 2 878 002      WO-A1-2015/047233
CN-A- 107 689 362      US-A1- 2008 186 648
US-A1- 2009 079 029      US-A1- 2012 241 909
US-A1- 2015 076 657**

EP 4 220 674 B1

## Description

### Domaine technique

La présente description concerne de façon générale des composants électroniques et plus particulièrement des condensateurs.

### Technique antérieure

Les condensateurs sont des composants très présents dans les circuits électroniques. Les condensateurs sont des composants électroniques, comprenant généralement deux électrodes séparées par une couche isolante. CN 107 689 362 A divulgue un condensateur vertical.

Dans le cadre de la miniaturisation des composants électroniques, on cherche aujourd'hui à augmenter la capacité obtenue pour une surface de substrat donnée.

### Résumé de l'invention

Le condensateur vertical selon l'invention est défini par les caractéristiques de la revendication 1. Le procédé de fabrication d'un condensateur vertical selon l'invention est défini par les caractéristiques de la revendication 10.

Les modes de réalisation correspondant à l'invention sont définis par les revendications. Les autres modes de réalisation décrits ne font pas partie de l'invention mais représentent des éléments de l'état de la technique utiles à la compréhension de l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, schématiquement et partiellement, deux modes de réalisation d'un condensateur ;

la figure 2 représente, en vue de dessus, des exemples d'une partie des structures de la figure 1 ;

la figure 3 représente, schématiquement et partiellement, deux structures résultant d'étapes d'un mode de réalisation d'un procédé de fabrication d'un condensateur ;

la figure 4 représente, schématiquement et partiellement, deux structures résultant d'autres étapes d'un mode de réalisation d'un procédé de fabrication d'un condensateur ;

la figure 5 représente, schématiquement et partiellement, une structure résultant d'une étape d'un mode de réalisation d'un procédé de fabrication d'un condensateur ; et

la figure 6 représente schématiquement et partiellement, un autre exemple d'un condensateur obtenu par la mise en oeuvre du procédé des figures 3 à 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

Sauf précision contraire, les expressions "environ", "approximativement", "sensiblement", et "de l'ordre de" signifient à 10 % près, de préférence à 5 % près.

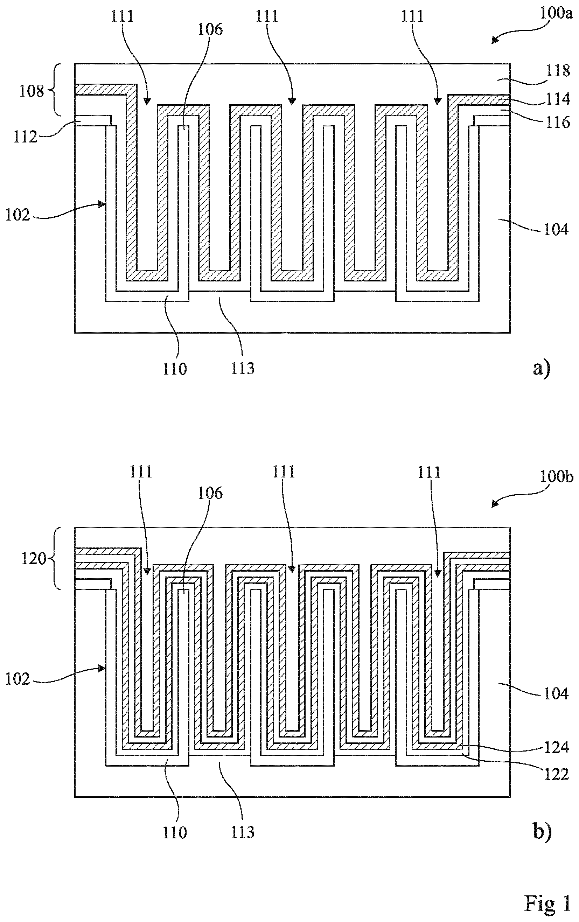

La figure 1 comprend deux vues en coupe, a) et b), représentant, schématiquement et partiellement, deux modes de réalisation d'un condensateur 100a ou 100b, par exemple situé dans une cavité 102 d'un substrat 104.

Les condensateurs 100a et 100b sont des condensateurs verticaux, c'est-à-dire des condensateurs comprenant un empilement de couches s'étendant au moins partiellement dans une direction sensiblement verticale. Par une direction sensiblement verticale, on entend une direction formant un angle de moins de 45 ° avec la direction verticale.

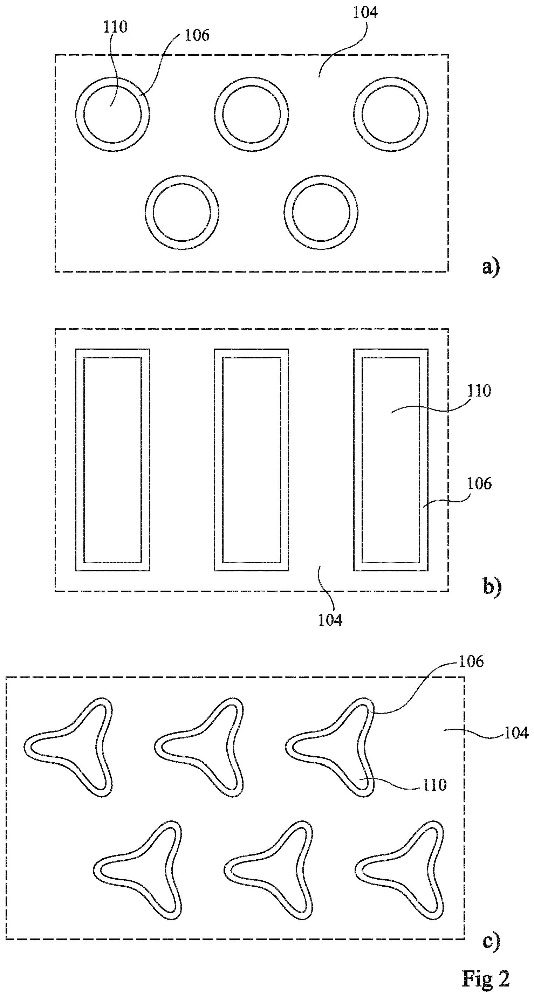

La vue a) illustre un condensateur 100a. Des murs 106 sont situés dans la cavité 102 et s'étendent à partir du fond de la cavité 102. Les murs 106 atteignent par exemple l'ouverture de la cavité 102. Les murs 106 forment les contours de formes géométriques, dont des exemples seront décrits en relation avec la figure 2. Les contours formés par les murs sont de préférence des contours fermés. Les régions du fond de la cavité 102 situées à l'intérieur des contours de chaque mur 106 sont de préférence recouvertes d'une portion 110 du matériau du mur 106. Ainsi, chaque mur 106 et la portion 110 correspondante forment un compartiment 111 comprenant un fond et des parois latérales.

Les régions 113 du substrat 104 situées entre les compartiments 111 ne sont de préférence pas recouvertes d'une couche isolante.

Une partie de certains murs 106 peut être en contact avec les parois de la cavité 102. De plus, des couches 108, par exemple en un matériau isolant, par exemple en le même matériau que les murs 106, sont situées sur la face supérieure du substrat 104 autour de la cavité 102.

Les murs 106 ont de préférence une épaisseur inférieure à 150 nm, par exemple inférieure à 100 nm, par exemple inférieure à 50 nm. De préférence, la face supérieure de chaque portion 110 est coplanaire avec le fond de la cavité 102 hors des contours formés par les murs 106.

Un empilement 108 de couches, constituant le condensateur 100a est déposé sur et entre les murs 106. Plus précisément, l'empilement 108 comprend des couches s'étendant de manière continue dans les compartiments 111, recouvrant les parois internes des murs 106 et les portions 110, et entre les compartiments 111, recouvrant les faces supérieures et les parois externes des murs 106 et les parties du substrat 104 situées entre les compartiments 111.

L'empilement 108, constituant le condensateur 100a, comprend une couche isolante 114 (hachurée en figure 1), entre deux couches conductrices 116 et 118 formant des électrodes. La couche conductrice 116 est la couche inférieure de l'empilement 108 et s'étend de manière conforme sur et entre les murs 106. La couche isolante 114 s'étend de manière conforme sur la couche 114. La couche 118 repose sur la couche isolante 116. La face supérieure de la couche 118 est de préférence sensiblement plane et situé au-dessus de la cavité 102.

L'empilement peut en outre s'étendre hors de la cavité 102. Plus précisément, l'empilement peut s'étendre sur au moins une partie des couches 112, hors de la cavité 102. Des contacts avec les couches conductrices 116 et 118, non représentés, sont par exemple situés hors de la cavité 102.

La vue b) illustre un condensateur 100b, comprenant une pluralité de condensateurs connectés en parallèle. La vue b) est similaire à la vue a) à l'exception de l'empilement de couches 108, qui est remplacé par un empilement de couches 120. L'empilement 120 comprend une alternance de couches conductrices 122 et de couches isolantes 124 (hachurées en figure 1). L'empilement 120 représenté en figure 1 comprend trois couches conductrices 122 et deux couches isolantes 124. L'empilement 120 peut cependant comprendre un nombre quelconque de couches isolantes 124, chacune située entre deux couches conductrices 122. La couche inférieure de l'empilement 120, c'est-à-dire la couche en contact avec les murs 106 et le substrat 104 entre les compartiments 111, est une couche conductrice 122. La couche supérieure de l'empilement 120 est une couche conductrice 122. La face supérieure de la couche supérieure de l'empilement 120 est de préférence sensiblement plane.

Des contacts avec chacune des couches conductrices 122, non représentés, sont par exemple situés hors de la cavité 102.

La figure 2 représente, en vue de dessus, des exemples d'une partie des modes de réalisation de la figure 1. Plus précisément, la figure 2 représente, en vue de dessus, trois exemples de structures a), b) et c) sur lesquelles les condensateurs 100a et 100b peuvent être formés. Ainsi, les vues des structures a), b) et c) correspondent à des vues de la cavité 102 sans les empilements 108 ou 120.

Le contour, de préférence fermé, formé par chaque mur 106 peut être sensiblement celui d'une forme quelconque, par exemple d'un cercle (structure a)), d'un rectangle (structure b)), d'un tripode (structure c)) d'un ovale, etc.

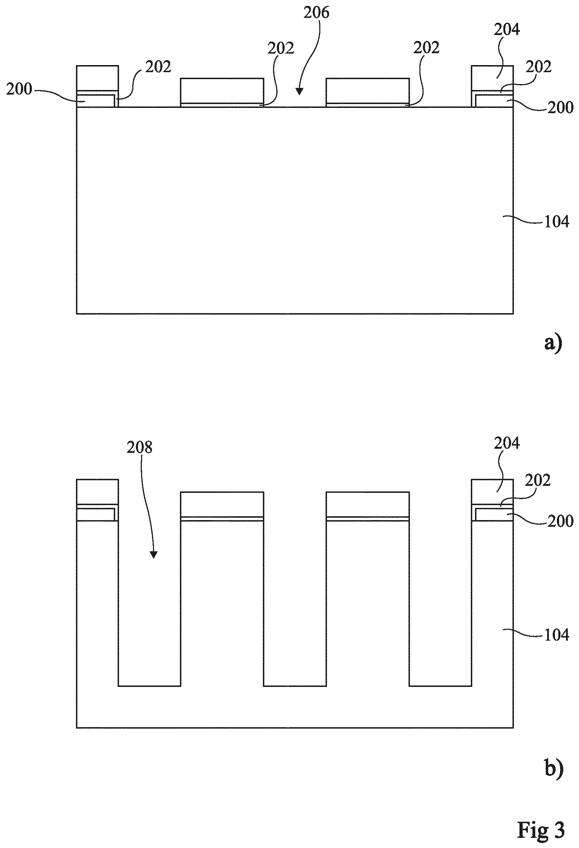

La figure 3 représente, schématiquement et partiellement, deux structures a) et b) résultant d'étapes d'un mode de réalisation d'un procédé de fabrication d'un condensateur.

La structure a) résulte d'une étape de formation d'une couche 200, par exemple en un matériau isolant, par exemple en oxyde de silicium, sur le substrat 104. Le substrat 104 est de préférence en un matériau pouvant être oxydé, par exemple en silicium.

La couche 200 comprend une ouverture à l'emplacement où l'on souhaite former la cavité 102, c'est-à-dire à l'emplacement du condensateur que l'on souhaite former.

Une couche 202 est ensuite formée sur la couche 200 et sur le substrat 104 dans l'ouverture de la couche 200. En particulier, la couche 202 recouvre les parois latérales de la couche 200, c'est-à-dire les parois de l'ouverture. La couche 202 est recouverte d'une couche 204. La couche 204 est de préférence en un matériau isolant, de préférence en le même matériau que la couche 200, par exemple en oxyde de silicium. La couche 202 est en un matériau pouvant être gravé sélectivement par rapport au matériau de la couche 204 et ne pouvant être oxydé, par exemple en nitrure de silicium. Des ouvertures sont ensuite formées dans les couches 202 et 204 aux emplacements des compartiments formés par les murs 106. Plus précisément, les ouvertures 206 dans la couche 202 ont la forme des formes géométriques dont le contour est tracé par les murs 106.

De préférence, les ouvertures dans les couches 202 et 204 sont formées de manière à conserver des portions de la couche 202 sur les parois de la couche 200. Ainsi, la couche 200 est entièrement protégée par la couche 202.

La structure b) résulte d'une étape de gravure au cours de laquelle le substrat est gravé à travers les ouvertures 206 de manière à former des cavités 208.

Les ouvertures des cavités ont par exemple des dimensions critiques comprises entre environ 0,5 $\mu$m et environ 1 $\mu$m et une profondeur comprise entre 35 et 45 $\mu$m.

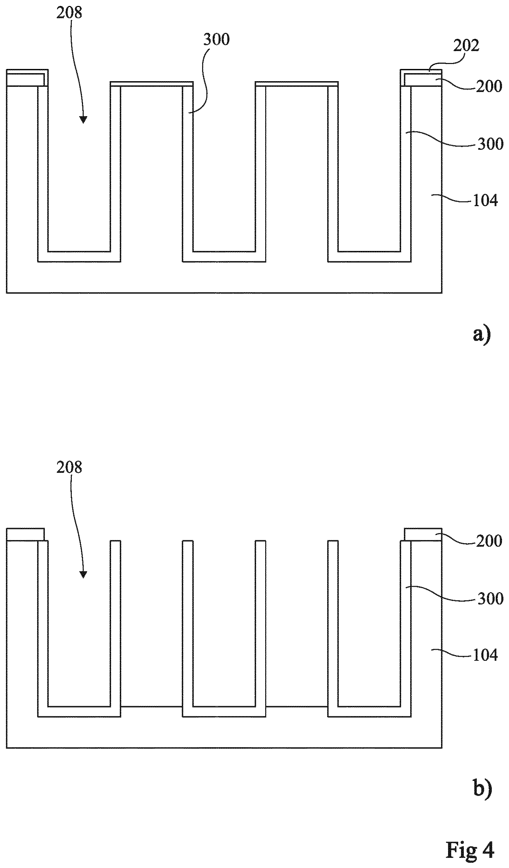

La figure 4 représente, schématiquement et partiellement, deux structures a) et b) résultant d'autres étapes d'un mode de réalisation d'un procédé de fabrication d'un condensateur.

La structure a) résulte d'une étape au cours de laquelle la couche 204 est retirée et au cours de laquelle une couche isolante 300 est formée sur les parois et le fond de chaque cavité 208. Les couches 300 sont par exemple formées en oxydant le matériau du substrat 104 au niveau des parois et du fond des cavités 208. Chaque couche 300 comprend une première portion située sur le fond de la cavité, et des deuxièmes portions s'étendant sur les parois de la cavité, entre le fond de la cavité et son ouverture. Les deuxièmes portions constitueront les murs 106 et les premières portions constitueront les portions 110.

L'épaisseur de la couche 300, et donc des murs 106, est de préférence inférieure à 150 nm, par exemple inférieure à 100 nm, par exemple inférieure à 50 nm.

La structure b) est obtenue après une étape de retrait de la couche 202 et une étape de gravure du substrat 104 situé entre les deuxièmes portions des couches 300. La gravure du substrat est par exemple maintenue jusqu'à atteindre le même niveau que la face supérieure du fond des cavités 208.

Le procédé de gravure du substrat 104 est choisi de manière à ne pas graver le matériau des couches 300 et 200. Les couches 200 permettent ainsi de protéger les parties du substrat 104 que l'on ne cherche pas à graver.

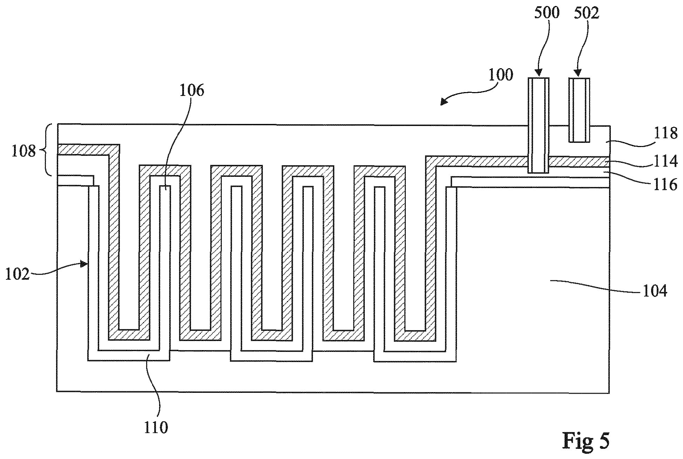

La figure 5 représente, schématiquement et partiellement, une structure résultant d'une autre étape d'un mode de réalisation d'un procédé de fabrication d'un condensateur.

Au cours de cette étape, l'empilement de couches 108 ou 120 formant le condensateur est formé. L'empilement représenté en figure 5 est l'empilement 108, comprenant une couche isolante 114 entre deux couches conductrices 116 et 118.

Les contacts avec les différentes couches conductrices sont ensuite formés. Il s'agit par exemple de vias isolés 500 et 502, comprenant un coeur conducteur entouré d'une gaine isolante. Le via isolé 502 permet la connexion électrique avec la couche conductrice 118. Le via isolé 500 traverse la couche conductrice 118 et la couche isolante 114 et permet la connexion électrique avec la couche conductrice 116.

Un avantage des modes de réalisation décrits est qu'ils permettent d'augmenter la capacité d'un condensateur sur une surface de substrat donné.

On aurait pu former des condensateurs en gravant des cavités dans le substrat et en formant l'empilement de couches constituant le condensateur dans les cavités et sur les parties (non gravées) du substrat situées entre les cavités, ces parties du substrat ayant alors une utilisation similaire à celle des murs 106. Cependant, les procédés de gravure actuels, par exemple les procédés de photolithographie, ne permettent pas de former des cavités profondes et étroites, c'est-à-dire ayant par exemple une profondeur supérieure à 20 $\mu$m, par exemple égale à 40 $\mu$m, et ayant par exemple des dimensions horizontales inférieures à 1 $\mu$m, séparées par des fines portions de substrat d'épaisseur, par exemple inférieure à 1 $\mu$m.

La capacité d'un condensateur comprenant une couche isolante entre deux couches conductrices est définie par l'équation suivante :

[Math 1]

$$C = \frac{\epsilon_r \epsilon_0 A}{d}$$

où d est l'épaisseur de la couche isolante, A est l'aire de l'interface entre la couche isolante et l'une des couches conductrices, $\epsilon_0$ est la permittivité du vide et $\epsilon_r$ est la permittivité relative du matériau de la couche isolante.

Ainsi, la diminution de l'épaisseur des murs permet d'augmenter l'aire A pour une surface de substrat donnée et donc la capacité du condensateur.

Il est possible de modifier différents critères de manière à obtenir des condensateurs adaptés aux diverses applications possibles. Ainsi, il est par exemple possible de modifier :

- la profondeur des cavités 102, et donc des cavités 208 ;
- le nombre de couches dans l'empilement 108 ou 120, et donc le nombre de condensateurs en parallèle ;
- le nombre de cavités 208 ; et
- les dimensions des ouvertures des cavités 208.

Par exemple, pour une surface de substrat donnée, il est possible de diminuer la profondeur du condensateur tout en conservant sensiblement la même valeur de capacité que dans le cas où les cavités sont séparées par des murs faits à partir du substrat 104.

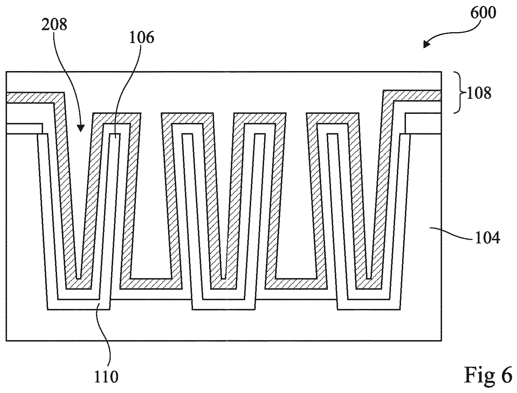

La figure 6 représente, schématiquement et partiellement, un autre exemple d'un condensateur obtenu par la mise en oeuvre du procédé des figures 3 à 5.

Dans ce mode de réalisation, les parois latérales de chaque mur 106 sont inclinées par rapport à la direction verticale, d'un angle inférieur à 45 °, par exemple de telle manière que la distance entre les parois près de la portion 110 est inférieure à la distance entre les faces supérieures des parois latérales du mur.

La forme penchée des murs peut par exemple être obtenue accidentellement lors du procédé de fabrication. Plus particulièrement, une telle forme peut être le résultat de l'étape de gravure des cavités 208 dans laquelle les parois de la cavité 208 obtenue ne sont pas droites.

Dans une structure où les cavités sont séparées par des régions de substrat, une telle forme de murs penchés entrainerait une diminution de la surface A du condensateur et donc une diminution de la capacité par rapport à la capacité que l'on aurait obtenue si les murs n'était pas penchés.

Dans le mode de réalisation de la figure 6, la diminution de la surface entrainée par la forme des cavités 208 est sensiblement compensée par les régions entre les cavités 208. Ces régions ont une forme complémentaire à la forme des cavités 208. Ainsi, la diminution de la surface A dans les cavités 208 est sensiblement compensée par l'augmentation de surface A entre les cavités 208.

Enfin, la mise en oeuvre pratique des modes de réalisation et variantes décrits est à la portée de l'homme du métier à partir des indications fonctionnelles données cidessus.

## Revendications

1. Condensateur vertical comprenant :

   - un substrat (104) en un premier matériau ;
   - une pluralité de compartiments (106, 110) espacés les uns des autres, la pluralité de compartiments (106, 110) étant en un deuxième matériau isolant différent du premier matériau, chaque compartiment (106, 110) comprenant une première portion de mur (106) inclinée, une deuxième portion de mur inclinée (106) et une troisième portion inférieure (110) entre les première et deuxième portions, la troisième portion inférieure reposant sur une quatrième portion du substrat, et
   - un empilement de couches (108, 120) recouvrant de manière conforme la pluralité de compartiments, des première et deuxième faces opposées l'une à l'autre de chaque première et deuxième portions de mur (106) de chaque compartiment étant recouvertes par l'empilement de couches (108, 120), des cinquièmes portions (113) du substrat séparant les compartiments et étant recouvertes de manière conforme par l'empilement de couches, l'empilement de couches comprenant au moins une première couche isolante (114) et deux deuxièmes couches conductrices (116, 118).

2. Condensateur selon la revendication 1, dans lequel une première distance entre les murs (106) de deux compartiments adjacents au niveau de la troisième portion (110) est inférieure à une deuxième distance entre les faces supérieures desdits murs.

3. Condensateur selon la revendication 1 ou 2, dans lequel le substrat comprend une première cavité (102), la pluralité de compartiments (106, 110) étant située dans la première cavité, les quatrièmes et cinquièmes portions du substrat étant dans la première cavité.

4. Condensateur, selon l'une quelconque des revendications 1 à 3, dans lequel les premières et deuxièmes portions de murs sont inclinées par rapport à la direction verticale, d'un angle inférieur à 45 °.

5. Condensateur (100a, 100b) selon l'une quelconque des revendications 1 à 4, dans lequel le deuxième matériau est de l'oxyde de silicium.

6. Condensateur (100a, 100b) selon l'une quelconque des revendications 1 à 5, dans lequel l'empilement (108, 120) comprend une alternance de premières couches isolantes et de deuxièmes couches conductrices, les couches inférieure (116) et supérieure (118) de l'empilement étant des deuxièmes couches conductrices.

7. Condensateur (100a, 100b) selon l'une quelconque des revendications 1 à 6, dans lequel chaque mur (106) forme, en vue de dessus, le contour d'une forme géométrique.

8. Condensateur (100a, 100b) selon l'une quelconque des revendications 1 à 7, dans lequel l'épaisseur de chaque mur (106) est inférieure à 150 nm.

9. Condensateur (100a, 100b) selon l'une quelconque des revendications 1 à 8, dans lequel le premier matériau est un matériau pouvant être oxydé.

10. Procédé de fabrication d'un condensateur (100a, 100b) vertical comprenant :

   - la formation d'un substrat (104) en un premier matériau ;
   - la formation d'une pluralité de compartiments (106, 110) espacées les uns des autres, la pluralité de compartiments (106, 110) étant en un deuxième matériau isolant différent du premier matériau, chaque compartiment (106, 110) comprenant une première portion de mur (106) inclinée, une deuxième portion de mur inclinée (106) et une troisième portion inférieure (110) entre les première et deuxième portions, la troisième portion inférieure reposant sur une quatrième portion du substrat, et
   - la formation d'un empilement de couches (108, 120) recouvrant de manière conforme la pluralité de compartiments, des première et deuxième faces opposées l'une à l'autre de chaque première et deuxième portions de mur (106) de chaque compartiment étant recouvertes par l'empilement de couches (108, 120), des cinquièmes portions (113) du substrat séparant les compartiments et étant recouvertes de manière conforme par l'empilement de couches, l'empilement de couches comprenant au moins une première couche isolante (114) et deux couches conductrices (116, 118).

11. Procédé selon la revendication 10, comprenant une étape de formation de cavités (208) dans le substrat (104).

12. Procédé selon la revendication 11, comprenant une étape de formation des murs (106) dans laquelle une deuxième couche isolante (300) est formée sur les parois et les fonds de chaque cavité (208).

13. Procédé selon la revendication 12, dans lequel les deuxièmes couches isolantes (300) sont formées par oxydation sur le substrat (104).

14. Procédé selon l'une quelconque des revendications 11 à 13, comprenant une étape de gravure des portions de substrat (104) situées entre les cavités (208).

**Patentansprüche**

1. Vertikaler Kondensator, aufweisend:

- ein Substrat (104) aus einem ersten Material;
- einer Vielzahl von voneinander beabstandeten Kammern (106, 110), wobei die Vielzahl von Kammern (106, 110) aus einem zweiten Isoliermaterial besteht, das sich vom ersten Material unterscheidet, wobei jede Kammer (106, 110) einen ersten geneigten Wandabschnitt (106), einen zweiten geneigten Wandabschnitt (106) und einen dritten unteren Abschnitt (110) zwischen dem ersten und dem zweiten Abschnitt aufweist, wobei der dritte untere Abschnitt auf einem vierten Abschnitt des Substrats aufliegt, und
- einen Stapel von Schichten (108, 120), der die Vielzahl von Kammern konform bedeckt, wobei die ersten und zweiten gegenüberliegenden Flächen jedes ersten und zweiten Wandabschnitts (106) jeder Kammer mit dem Stapel von Schichten (108, 120) bedeckt sind, wobei fünfte Abschnitte (113) des Substrats die Kammern trennen und konform mit dem Stapel von Schichten bedeckt sind, wobei der Stapel von Schichten mindestens eine erste Isolierschicht (114) und zwei zweite leitfähige Schichten (116, 118) aufweist.

2. Kondensator nach Anspruch 1, wobei ein erster Abstand zwischen den Wänden (106) zweier benachbarter Kammern, auf Höhe des dritten Abschnitts (110), kleiner ist als ein zweiter Abstand zwischen den oberen Flächen der Wände.

3. Kondensator nach Anspruch 1 oder 2, wobei das Substrat einen ersten Hohlraum (102) aufweist, wobei sich die Vielzahl von Kammern (106, 110) innerhalb des ersten Hohlraums befindet und wobei sich der vierte und fünfte Abschnitt des Substrats innerhalb des ersten Hohlraums befinden.

4. Kondensator nach einem der Ansprüche 1 bis 3, wobei die ersten und zweiten Abschnitte der Wände in Bezug auf die vertikale Richtung in einem Winkel von weniger als 45° geneigt sind.

5. Kondensator (100a, 100b) nach einem der Ansprüche 1 bis 4, wobei das zweite Material Siliziumoxid ist.

6. Kondensator (100a, 100b) nach einem der Ansprüche 1 bis 5, wobei der Stapel (108, 120) abwechselnd erste Isolierschichten und zweite leitfähige Schichten aufweist, wobei die untere (116) und die obere (118) Schicht im Stapel zweite leitfähige Schichten sind.

7. Kondensator (100a, 100b) nach einem der Ansprüche 1 bis 6, wobei jede Wand (106) in der Draufsicht die Kontur einer geometrischen Form bildet.

8. Kondensator (100a, 100b) nach einem der Ansprüche 1 bis 7, wobei die Dicke jeder Wand (106) weniger als 150 nm beträgt.

9. Kondensator (100a, 100b) nach einem der Ansprüche 1 bis 8, wobei das erste Material ein Material ist, das oxidiert werden kann.

10. Verfahren zur Herstellung eines vertikalen Kondensators (100a, 100b), aufweisend:

- Ausbilden eines Substrats (104) aus einem ersten Material;
- Ausbilden einer Vielzahl von voneinander beabstandeten Kammern (106, 110), wobei die Vielzahl von Kammern (106, 110) aus einem zweiten Isoliermaterial hergestellt ist, das sich vom ersten Material unterscheidet, wobei jede Kammer (106, 110) einen ersten geneigten Wandabschnitt (106), einen zweiten geneigten Wandabschnitt (106) und einen dritten unteren Abschnitt (110) zwischen dem ersten und dem zweiten Abschnitt aufweist, wobei der dritte untere Abschnitt auf einem vierten Abschnitt des Substrats aufliegt, und
- Ausbilden eines Stapels von Schichten (108, 120), der die Vielzahl von Kammern konform bedeckt, wobei die ersten und zweiten gegenüberliegenden Flächen jedes ersten und zweiten Wandabschnitts (106) jeder Kammer mit dem Stapel von Schichten (108, 120) bedeckt sind, wobei fünfte Abschnitte (113) des Substrats die Kammern trennen und konform mit dem Stapel von Schichten bedeckt sind, wobei der Stapel von Schichten mindestens eine erste Isolierschicht (114) und zwei zweite leitfähige Schichten (116, 118) aufweist.

11. Verfahren nach Anspruch 10, aufweisend einen Schritt zum Ausbilden von Hohlräumen (208) innerhalb des Substrats (104).

12. Verfahren nach Anspruch 11, aufweisend einen Schritt zum Ausbilden von Wänden (106), wobei eine zweite Isolierschicht (300) an den Seitenwänden und den Böden jedes Hohlraums (208) gebildet wird.

13. Verfahren nach Anspruch 12, wobei die zweiten Isolierschichten (300) durch Oxidation auf dem Substrat (104) gebildet werden.

14. Verfahren nach einem der Ansprüche 11 bis 13, aufweisend einen Schritt zum Ätzen der Substratabschnitte (104), die sich zwischen den Hohlräumen (208) befinden.

## Claims

1. Vertical capacitor comprising:

   - a substrate (104) made of a first material;
   - a plurality of compartments (106, 110) spaced apart from each other, the plurality of compartments (106, 110) being made of a second insulating material different from the first material, each compartment (106, 110) comprising a first inclined wall portion (106), a second inclined wall portion (106) and a third lower portion (110) between the first and second portions, the third lower portion resting on a fourth portion of the substrate, and
   - a stack of layers (108, 120) conformingly covering the plurality of compartments, first and second opposite faces of each first and second wall portions (106) of each compartment being covered with the stack of layers (108, 120), fifth portions (113) of the substrate separating the compartments and being conformingly covered with the stack of layers, the stack of layers comprising at least one first insulating layer (114) and two second conductive layers (116, 118).

2. Capacitor according to claim 1, wherein a first distance between the walls (106) of two compartments adjacent at the level of the third portion (110) is less than a second distance between the upper faces of said walls.

3. Capacitor according to claim 1 or 2, wherein the substrate comprises a first cavity (102), the plurality of compartments (106, 110) being located within the first cavity, the fourth and fifth portions of the substrate being within the first cavity.

4. Capacitor, according to any one of claims 1 to 3, wherein the first and second portions of walls are inclined with respect to the vertical direction, at an angle of less than 45°.

5. Capacitor (100a, 100b) according to any one of claims 1 to 4, wherein the second material is silicon oxide.

6. Capacitor (100a, 100b) according to any one of claims 1 to 5, wherein the stack (108, 120) comprises an alternation of first insulating layers and of second conductive layers, the lower (116) and upper (118) layers in the stack being second conductive layers.

7. Capacitor (100a, 100b) according to any one of claims 1 to 6, wherein each wall (106) forms, in top view, the contour of a geometric shape.

8. Capacitor (100a, 100b) according to any one of claims 1 to 7, wherein the thickness of each wall (106) is less than 150 nm.

9. Capacitor (100a, 100b) according to any one of claims 1 to 8, wherein the first material is a material capable of being oxidized.

10. Method for manufacturing a vertical capacitor (100a, 100b) comprising:

    - forming a substrate (104) made of a first material;
    - forming a plurality of compartments (106, 110) spaced apart from each other, the plurality of compartments (106, 110) being made of a second insulating material different from the first material, each compartment (106, 110) comprising a first inclined wall portion (106), a second inclined wall portion (106) and a third lower portion (110) between the first and second portions, the third lower portion resting on a fourth portion of the substrate, and
    - forming a stack of layers (108, 120) conformingly covering the plurality of compartments, first and second opposite faces of each first and second wall portions (106) of each compartment being covered with the stack of layers (108, 120), fifth portions (113) of the substrate separating the compartments and being conformingly covered with the stack of layers, the stack of layers comprising at least one first insulating layer (114) and two second conductive layers (116, 118).

11. Method according to claim 10, comprising a step for forming cavities (208) within the substrate (104).

12. Method according to claim 11, comprising a step for forming walls (106) wherein a second insulating layer (300) is formed on the sidewalls and the bottoms of each cavity (208).

13. Method according to claim 12, wherein the second insulating layers (300) are formed by oxidation on the substrate (104).

14. Method according to any one of claims 11 to 13, comprising a step for etching the substrate portions (104) located between the cavities (208).

a)

b)

Fig 1

a)

b)

c)

Fig 2

a)

b)

Fig 3

a)

b)

Fig 4

Fig 5

Fig 6

# EP 4 220 674 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 107689362 A